(19) Europäisches Patentamt
European Patent Office
Office européen des brevets

(11) **EP 2 172 502 B1**

(12) **EUROPÄISCHE PATENTSCHRIFT**

(45) Veröffentlichungstag und Bekanntmachung des Hinweises auf die Patenterteilung:
**20.04.2016 Patentblatt 2016/16**

(51) Int Cl.:
*C08G 18/48* (2006.01)     *C08G 18/67* (2006.01)
*C08G 18/77* (2006.01)     *G03F 7/00* (2006.01)
*G11B 7/245* (2006.01)

(21) Anmeldenummer: **09011897.7**

(22) Anmeldetag: **18.09.2009**

(54) **POLYETHERBASIERTE POLYURETHANFORMULIERUNGEN ZUR HERSTELLUNG HOLOGRAFISCHER MEDIEN**

POLYETHER-BASED POLYURETHANE FORMULATIONS FOR PRODUCING HOLOGRAPHIC MEDIA

FORMULES DE POLYURÉTHANE À BASE DE POLYÉTHER POUR LA FABRICATION DE SUPPORTS HOLOGRAPHIQUES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **01.10.2008 EP 08017277**

(43) Veröffentlichungstag der Anmeldung:
**07.04.2010 Patentblatt 2010/14**

(73) Patentinhaber: **Covestro Deutschland AG**
**51373 Leverkusen (DE)**

(72) Erfinder:
• **Weiser, Marc-Stephan, Dr.**
**51379 Leverkusen (DE)**
• **Roelle, Thomas, Dr.**
**51381 Leverkusen (DE)**
• **Bruder, Friedrich-Karl, Dr.**
**47802 Krefeld (DE)**
• **Fäcke, Thomas, Dr.**
**51375 Leverkusen (DE)**
• **Hönel, Dennis**
**53909 Zülpich (DE)**

(74) Vertreter: **Levpat**
**c/o Covestro AG**
**Alfred-Nobel-Straße 10**
**40789 Monheim am Rhein (DE)**

(56) Entgegenhaltungen:
WO-A-03/102959     WO-A-2008/125199
US-A- 4 247 578     US-A1- 2007 072 124

**Beschreibung**

Die vorliegende Erfindung betrifft neuartige Polyurethanzusammensetzungen, welche sich für die Herstellung holographischer Medien unter anderem für die Datenspeicherung, allerdings auch für optische Anwendungen verschiedenster Art in vorteilhafter Weise eignen.

Beim Aufbau holographischer Medien, wie sie in US 6,743,552 beschrieben sind, erfolgt die Speicherung von Informationen in einer Polymerschicht, welche im Wesentlichen aus einem Matrixpolymer und sehr speziellen darin gleichmäßig verteilt vorliegenden polymerisierbaren Monomeren besteht. Dieses Matrixpolymer kann auf Polyurethanbasis sein. Zu dessen Herstellung wird von isocyanat-funktionellen Materialien ausgegangen, welche mit Polyolen wie Polyethern oder Polyestern unter Urethanbildung vernetzt werden.

Aus US 6,743,552, US 6,765,061 und US 6,780,546 sind Polyether-basierende PU-Matrices für den Einsatz in holografischen Medien bekannt, die im Wesentlichen auf trifunktionellen Polypropylenoxid (PPO) bzw. Mischungen von Poly(THF) mit trifunktionellen PPO basieren. Die dort beschriebenen Formulierungen enthalten zum Teil PPO mit geringer Molmasse (Mn ≤ 1000 g/Mol) bzw. in Mischung mit Poly(THF) auch mit Molmassen bis zu Mn ≤ 1500 g/Mol. Ein sehr ähnlicher Ansatz ist in JP 2008015154 A 20080124 beschrieben. Hier wurde die Matrix aus difunktionellen Isocyanaten und Mischungen von Poly(THF) und trifunktionellen PPO gebildet. Ebenso wird in US 2003044690 A1 20030306 die Synthese einer PU-Matrix aus Desmodur® N 3400, Desmodur® N 3600 bzw. Baytec WE-180 sowie einem trifunktionellern PPO auf Basis Glycerin mit Mn 1000 beschrieben. Darüber hinaus wurden in JP 2008070464 A 20080327 polyetherbasierte PU-Matrices mit höheren Tg-Werten (> 30 °C) für holografische Medien eingesetzt. In WO 2008029765 A1 20080313 wurden Polyester- und Polycarbonat-basierte Polyole als Komponenten für Polyurethan-Matrices für Volumenhologramme und holografische Medien verwendet. In WO 2005116756 A2 20051208 sind niedrig Tg-Polyurethan-Matrices auf Basis von einer Mischung aus Polyestern und Surfynol 440 (Air Products and Chemicals, Inc., Allentown, USA), einem Polyether mit Alkin-diol-Starter für Prägehologramme, beschrieben.

Weiterhin wird in den Patenten JP 2007101743, JP 2007086234, JP 2007101881, US 20070077498 und US 20070072124 der Einsatz von di- und trifunktionellem Polypropylenoxid im Rahmen von PU-Matrices im Bereich der holografischen Datenspeicher oder als "volume-type holographic optical recording media" beschrieben. Als Isocyanatkomponente wurde dabei Dicyclohexylmethan-4,4'-diisocyanat ("H12-MDI") oder ein Präpolymer der oben genannten Komponenten, teilweise in Gegenwart von 1,4-Butandiol als Kettenverlängerer eingesetzt. Analoge Formulierungen sind aus den Patenten JP 2007187968 und JP 2007272044 für den Bereich "information recording and fixation" und "high density volume holographic recording material" bekannt. Im Patent JP 2008070464 wird eine analoge Formulierung als Matrixmaterial für holografische Datenspeicher sowie "holographic recording materials and recording media" beschrieben. In diesem Fall wurde Polyethylenglykol der zahlenmittleren Molmasse (Mn) 600 g/Mol als Kettenverlängerer verwendet und neben "H12-MDI" auch Hexamethylendiisocyanat eingesetzt. Im Patent JP 2007279585 wurde ein trifunktionelles Polyproylenoxid in Verbindung mit Hexamethylendiisocyanat und/oder Desmodur® N3300 als Matrixmaterial für die Herstellung von "holographic recording layers" und einem "optical recording medium" beschrieben.

Nachteilig an den bekannten Systemen auf Polyurethanbasis ist jedoch insbesondere für optische Anwendungen außerhalb der digitalen Datenspeicherung, dass die erzielbare Helligkeit der in solchen Medien gespeicherten Hologramme zu niedrig ist. Grund hierfür ist meist, dass der relative Unterschied der Brechungsindices von Polyurethanmatrix und Schreibmonomer zu gering ist. Eine beliebige Variation des Matrixpolymers ist hingegen nicht möglich, da stets eine gute Verträglichkeit von Matrixpolymer mit Schreibmonomer und den weiteren in den Formulierungen enthaltenen Komponenten gewährleistet sein muss. Ferner ist aus verarbeitungstechnischen Gründen eine möglichst einfach durchzuführende Vermischung und Bereitstellung der Formulierungen von Interesse.

Aufgabe der vorliegenden Erfindung war es daher nun neue Polyurethanzusammensetzungen bereitzustellen, welche ohne Einbußen auf Seiten der Verträglichkeiten von Matrixpolymer und Schreibmonomer ein besseres Kontrastverhältnis und eine verbesserte Helligkeit der Hologramme ermöglichen.

Es wurde nun überraschenderweise gefunden, dass sich die oben genannten Anforderungen erfüllen lassen, wenn zum Aufbau des Matrixpolymers spezielle Polyetherpolyole verwendet werden.

Gegenstand der Erfindung sind daher Polyurethanzusammensetzungen, umfassend

A) eine Polyisocyanatkomponente,

B) eine isocyanatreaktive Komponente umfassend zu mindestens 50 Gew.-% bezogen auf die Gesamtmenge von B) Polyetherpolyole B1) mit zahlenmittleren Molkulargewichten von größer 1000 g/Mol, die eine oder mehrere Oxyalkyleneinheiten der Formeln (I) bis (III) aufweisen

$$-CH_2-CH_2-O- \qquad \text{Formel (I)}$$

$$-CH_2-CH(R)-O- \qquad \text{Formel (II)}$$

$$-CH_2-CH_2-CH_2-O- \qquad \text{Formel (III)}$$

wobei

R ein Alkyl-, oder Arylrest, ist, der auch substituiert oder durch Heteroatome (wie Ethersauerstoffe) unterbrochen sein kann.

C) Verbindungen, die unter Einwirkung aktinischer Strahlung mit ethylenisch ungesättigten Verbindungen unter Polymerisation reagierende Gruppen (strahlenhärtende Gruppen) aufweisen und selbst frei von NCO-Gruppen sind.

D) Radikalstabilisatoren

E) Photoinitiatoren

F) gegebenenfalls Katalysatoren

G) gegebenenfalls Hilfs- und Zusatzstoffe dadurch gekennzeichnet, dass in C) Urethanacrylate und/oder Urethanmethacrylate eingesetzt werden.

Unter aktinischer Strahlung wird elektromagnetische, ionisierende Strahlung verstanden, insbesondere Elektronenstrahlen, UV-Strahlen sowie sichtbares Licht (Roche Lexikon Medizin, 4.Auflage; Urban & Fischer Verlag, München 1999).
Typische Polyurethanzusammensetzungen umfassen:

5 bis 93.999 Gew.-% der erfindungswesentlichen Komponenten B),

1 bis 60 Gew.-% Komponente A)

5 bis 70 Gew.-% der Komponente C)

0.001 bis 10 Gew.-% Photoinitiatoren E),

0 bis 10 Gew.-% Radikalstabilisatoren D)

0 bis 4 Gew.-% Katalysatoren F)

0 bis 70 Gew.-% Hilfs- und Zusatzstoffe G)

Bevorzugt umfassen die erfindungsgemäßen Polyurethanzusammensetzungen

15 bis 82.989 Gew.-% der erfindungswesentlichen Komponenten B),

2 bis 40 Gew.-% Komponente A)

15 bis 70 Gew.-% der Komponente C)

0.01 bis 7.5 Gew.-% Photoinitiatoren E),

0.001 bis 2 Gew.-% Radikalstabilisatoren D)

0 bis 3 Gew.-% Katalysatoren F)

0 bis 50 Gew.-% Hilfs- und Zusatzstoffe G)

Besonders bevorzugt umfassen die erfindungsgemäßen Polyurethanzusammensetzungen

15 bis 82.489 Gew.-% der erfindungswesentlichen Komponenten B),

2 bis 40 Gew.-% Komponente A)

15 bis 50 Gew.-% der Komponente C)

0.5 bis 5 Gew.-% Photoinitiatoren E),

0.01 bis 0,5 Gew.-% Radikalstabilisatoren D)

0.001 bis 2 Gew.-% Katalysatoren F)

0 bis 35 Gew.-% Hilfs- und Zusatzstoffe G)

Als Verbindungen der Polyisocyanatkomponente A) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte (Oligo- und Polyisocyanate) monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.
Beispielsweise geeignete monomere Di- oder Triisocyanat sind Butylendiisocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)oktan, Isocyanatomethyl-1,8-octandiisocyanat (TIN), 2,4- und/oder 2,6-Toluylen-diisocyanat.
Ebenfalls möglich ist der Einsatz von isocyanatfunktionellen Prepolymeren mit Urethan-, Allophanat- oder Biuretstrukturen als Verbindungen der Komponente A), wie sie in an sich gut bekannter Art und Weise durch Umsetzung der vorgenannten Di-, Tri- oder Polyisocyanate im Überschuss mit hydroxy- oder aminofunktionellen Verbindungen erhalten werden können. Eventuell nicht umgesetztes Ausgangsisocyanat kann anschließend noch entfernt werden, um monomerenarme Produkte zu erhalten. Zur Beschleunigung der Prepolymerbildung kann der Einsatz von dem Fachmann an sich aus der Polyurethanchemie gut bekannten Katalysatoren hilfreich sein.
Als hydroxy- oder aminofunktionellen Verbindungen zum Prepolymeraufbau eignen sich typischerweise niedermolekulare kurzkettige, d.h. 2 bis 20 Kohlenstoffatome enthaltende aliphatische, araliphatische oder cycloaliphatische Diole, Triole und/oder höhere Polyole.
Beispiele für Diole sind Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure(2,2-dimethyl-3-hydroxypropylester).
Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.
Geeignet sind auch höhermolekulare aliphatische und cycloaliphatische Polyole wie Polyesterpolyole, Polyetherpolyole, Polycarbonatpolyole, hydroxyfunktionelle Acrylharze, hydroxyfunktionelle Polyurethane, hydroxyfunktionelle Epoxyharze oder entsprechende Hybride (vgl. Römpp Lexikon Chemie, S.465-466, 10. Aufl. 1998, Georg-Thieme-Verlag, Stuttgart).
Für den Prepolymeraufbau geeignete Polyesterpolyole sind lineare Polyesterdiole, wie sie in bekannter Weise aus aliphatischen, cycloaliphatischen oder aromatischen Di- bzw. Polycarbonsäuren bzw. ihren Anhydriden wie z. B. Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren Gemisch mit mehrwertigen Alkoholen wie z. B. Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12 oder deren Gemische gegebenenfalls unter Mitverwendung höherfunktioneller Polyole wie Trimethylolpropan oder Glycerin hergestellt werden können. Als mehrwertige Alkohole zur Herstellung der Polyesterpolyole kommen natürlich auch cycloaliphatische und/oder aromatische Di- und Polyhydroxylverbindungen in Frage. Anstelle der freien Polycarbonsäure können auch die entsprechenden Polycarbonsäureanhydride oder entsprechende Polycarbonsäureester von niedrigen Alkoholen oder deren Gemische zur Herstellung der Polyester verwendet werden.
Ebenfalls zum Prepolymeraufbau geeignete Polyesterpolyole sind Homo- oder Mischpolymerisate von Lactonen, die vorzugsweise durch Anlagerung von Lactonen bzw. Lactongemischen wie Buty-rolacton, ε-Caprolacton und/oder Methyl-ε-caprolacton an geeignete di- und /oder höherfunktionelle Startermoleküle, wie z. B. die vorstehend als Aufbaukomponenten für Polyesterpolyole genannten niedermolekularen, mehrwertigen Alkohole, erhalten werden.

Auch Hydroxylgruppen aufweisenden Polycarbonate kommen als Polyhydroxylkomponente für den Prepolymeraufbau in Betracht, z. B. solche, die durch Umsetzung von Diolen wie 1,4-Butandiol und/oder 1,6-Hexandiol und/oder 3-Methylpentandiol mit Diarylcarbonaten, z. B. Diphenylcarbonat, Dimethylcarbonat oder Phosgen hergestellt werden können.

Zum Prepolymeraufbau geeignete Polyetherpolyole sind z. B. die Polyadditionsprodukte der Styroloxide, des Ethylenoxid, Propylenoxid, Tetrahydrofuran, Butylenoxid, Epichlorhydrins, sowie ihre Mischadditions- und Pfropfprodukte, sowie die durch Kondensation von mehrwertigen Alkoholen oder Mischungen derselben und die durch Alkoxylierung von mehrwertigen Alkoholen, Aminen und Aminoalkoholen gewonnenen Polyetherpolyole. Bevorzugte Polyetherpolyole sind Poly(propylenoxid)e, Poly(ethylenoxide) und deren Kombinationen in Form von statistischen oder Blockcopolymeren oder Poly(tetrahydrofuran)e sowie Mischungen derselben mit einer OH-Funktionalität von 1,5 bis 6 und einem zahlenmittleren Molekulargewicht von zwischen 200 bis 18000 g/Mol, bevorzugt mit einer OH-Funktionalität von 1,8 bis 4,0 und einem zahlenmittleren Molekulargewicht von 600 bis 8000 g/Mol und besonders bevorzugt mit einer OH-Funktionalität von 1,9 bis 3,1 und einem zahlenmittleren Molekulargewicht von 650 bis 4500 g/Mol.

Als Amine eignen sich für den Prepolymeraufbau alle oligomeren oder polymeren, primären oder sekundären, di-, tri- oder polyfunktionellen Amine. Dies können beispielsweise sein: Ethylendiamin, Diethylentriamin, Triethylentetramin, Propylendiamin, Diamino-cyclohexan, Diaminobenzol, Diaminobisphenyl, Triaminobenzol, di-, tri- und höherfunktionelle Polyamine wie z.B. die Jeff-amine®, aminterminierte Polymere mit zahlenmittleren Molmassen bis 10000 g/Mol oder deren beliebige Gemische untereinander.

Bevorzugte Prepolymere sind solche basierend auf den vorgenannten Aufbaukomponenten mit Urethan- und/oder Allophanatgruppen mit zahlenmittleren Molekulargewichten von 200 bis 10000 g/Mol, bevorzugt mit zahlenmittleren Molekulargewichten von 500 bis 8000 g/Mol. Besonders bevorzugte Prepolymere sind Allophanate basierend auf HDI oder TMDI und di- oder trifunktionellen Polyetherpolyolen mit zahlenmittleren Molmassen von 1000 bis 8000 g/Mol.

Es ist gegebenenfalls auch möglich, dass die Isocyanatkomponente A anteilsmäßig Isocyanate enthält, die teilweise mit isocyanat-reaktiven ethylenisch ungesättigten Verbindungen umgesetzt sind. Bevorzugt werden hierbei als isocyanat-reaktive ethylenisch ungesättigte Verbindungen $\alpha,\beta$-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt. Besonders bevorzugt sind Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth)acrylat, Polyethylenoxid-mono(meth)acrylate, Polypropylenoxidmono(meth)acrylate, Polyalkylenoxidmono(meth)acrylate, Poly($\epsilon$-caprolacton)mono(meth)-acrylate, wie z.B. Tone® M100 (Dow, USA), 2-Hydroxypropyl(meth)acrylat, 4-Hydroxybutyl(meth)acrylat, 3-Hydroxy-2,2-dimethylpropyl(meth)acrylat, die hydroxyfunktionellen Mono-, Di- oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Der Anteil an Isocyanaten, die teilweise mit isocyanat-reaktiven ethylenisch ungesättigten Verbindungen umgesetzt sind, an der Isocyanatkomponente A beträgt 0 bis 99 %, bevorzugt 0 bis 50 %, besonders bevorzugt 0 bis 25 % und ganz besonders bevorzugt 0 bis 15 %.

Die NCO-Gruppen der Polyisocyanate der Komponente A) können auch ganz oder teilweise mit den an sich in der Technik üblichen Blockierungsmitteln blockiert sein. Dies sind beispielsweise Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, $\epsilon$-Caprolactam, N-tert.-Butyl-benzylamin, Cyclopentanoncarboxyethylester oder beliebige Gemische dieser Blockierungsmittel.

Bevorzugt werden in A) Polyisocyanate und/oder Präpolymere der vorstehend genannten Art basierend auf HDI, TMDI und/oder TIN eingesetzt.

Besonders bevorzugt werden Polyisocyanate basierend auf HDI mit Isocyanurat- und/oder Iminooxadiazindionstrukturen eingesetzt.

Ebenfalls besonders bevorzugt ist der Einsatz von Präpolymeren bevorzugt mit NCO-Funktionalitäten von 2 bis 5, besonders bevorzugt solchen mit primären NCO-Gruppen. Beispiele solcher Präpolymere sind Allophanate oder Urethane oder deren Mischungen bevorzugt auf Basis von HDI und/oder TMDI und Polyether- und/oder Polyester- bzw. Polycarbonatpolyolen.

Bevorzugt weisen die vorstehend genannten Polyisocyanate bzw. Präpolymere Restgehalte an freiem monomeren Isocyanat von weniger als 1 Gew.-%, besonders bevorzugt weniger als 0,5 Gew.-%, ganz besonders bevorzugt weniger als 0,2 Gew.-% auf.

In Formel (II) ist R ein Alkyl-, oder Arylrest, ist, der auch substituiert oder durch andere Atome (wie Ethersauerstoffe) unterbrochen sein kann. Bevorzugt sind Methyl-, Butyl-, Hexyl- und Octylreste sowie Alkylreste, deren C-Kette durch Ethersauerstoffatome unterbrochen sind. Bei letzteren sind besonders bevorzugt solche mit ein bis 50 1-Alkylenoxideinheiten.

Die erfindungswesentlichen Polyetherpolyole B1) können Homopolymere basierend auf einem Startermolekül und ausschließlich gleichen Oxyalkylen-Wiederholungseinheiten sein. Ebenso möglich sind statistische oder Block-Copolymere mit verschiedenen Oxyalkyleneinheiten.

Solche Polyetherpolyole sind beispielsweise die Polyadditionsprodukte von Styroloxiden, Ethylenoxid, Propylenoxid, Butylenoxid, Epichlorhydrins, höherer 1-Alkenoxide sowie ihre Mischadditions- und Pfropfprodukte, sowie die durch Kondensation von mehrwertigen Alkoholen oder Mischungen derselben und die durch Alkoxylierung von mehrwertigen Alkoholen, Aminen und Aminoalkoholen gewonnenen Polyetherpolyole genannt.

Diese sind beispielsweise durch Addition der vorgenannten cyclischen Ether an NH- oder OHfunktionelle Startermoleküle erhältlich.

Geeignete Starterverbindungen mit Zerewitinoff-aktiven Wasserstoffatomen weisen meist Funktionalitäten von 1 bis 8 auf. An N, O oder S gebundener Wasserstoff wird als Zerewitinoff-aktiver Wasserstoff (manchmal auch nur als "aktiven Wasserstoff") bezeichnet, wenn er nach einem von Zerewitinoff aufgefundenen Verfahren durch Umsetzung mit Methylmagnesiumjodid Methan liefert. Ihre Molmassen betragen von 60 g/Mol bis 1.200 g/Mol. Neben hydroxyfunktionellen Startern können auch amino-funktionelle Starter eingesetzt werden. Beispiele für hydroxy-funktionelle Starterverbindungen sind Methanol, Ethanol, 1-Propanol, 2-Propanol und höhere aliphatische Monole, insbesondere Fettalkohole, Phenol, alkylsubstituierte Phenole, Propylenglykol, Ethylenglykol, Diethylenglykol, Dipropylenglykol, 1,2-Butandiol, 1,3-Butan-diol, 1,4-Butan-diol, Hexandiol, Pentandiol, 3-Methyl-1,5-pentandiol, 1,12-Dodecandiol, Glycerin, Trimethylolpropan, Triethanolamin, Pentaerythrit, Sorbit, Saccharose, Hydrochinon, Brenzcatechin, Resorcin, Bisphenol F, Bisphenol A, 1,3,5-Trihydroxybenzol, methylolgruppen-haltige Kondensate aus Formaldehyd und Phenol oder Melamin oder Harnstoff, sowie Mannichbasen. Beispiele für amino-gruppenhaltige Starterverbindungen sind Ammoniak, Ethanolamin, Diethanolamin, Isopropanolamin, Di-isopropanolamin, Ethylendiamin, Hexamethylendiamin, Anilin, die Isomere des Toluidins, die Isomere des Diaminotoluols, die Isomere des Diaminodiphenylmethans sowie bei der Kondensation von Anilin mit Formaldehyd zu Diaminodiphenylmethan anfallende höherkernige Produkte. Außerdem können als Starterverbindungen auch Ringöffnungsprodukte aus cyclischen Carbonsäureanhydriden und Polyolen eingesetzt werden. Beispiele sind Ringöffnungsprodukte aus Phthalsäureanhydrid, Bernsteinsäureanhydrid, Maleinsäureanhyid einerseits und Ethylenglykol, Diethylenglykol, 1,2-Butandiol, 1,3-Butandiol, 1,4-Butandiol, Hexandiol, Pentandiol, 3-Methyl-1,5-pentandiol, 1,12-Dodecandiol, Glycerin, Trimethylolpropan, Pentaerythrit oder Sorbit andererseits. Daneben ist es auch möglich, ein- oder mehrfunktionelle Carbonsäuren direkt als Starterverbindungen einzusetzen. Es können natürlich auch Gemische verschiedener Starterverbindungen eingesetzt werden.

Die erwähnten, als Katalysator verwendbaren polymeren Alkoxylate werden in einem separaten Reaktionsschritt durch Alkylenoxidaddition an die oben erwähnten, zerewitinoff-aktive Wasserstoffatome enthaltenden Starterverbindungen hergestellt. Üblicherweise wird bei der Herstellung des polymeren Alkoxylates ein Alkali- oder Erdalkalimetallhydroxid, z. B. KOH, in Mengen von 0,1 bis 1 Gew.-%, bezogen auf die herzustellende Menge als Katalysator, eingesetzt, das Reaktionsgemisch, falls erforderlich, im Vakuum entwässert, die Alkylenoxidadditionsreaktion unter Inertgasatmosphäre bei 100 bis 170 °C bis zum Erreichen einer OH-Zahl von 150 bis 1.200 mg KOH/g durchgeführt und danach gegebenenfalls durch Zugabe weiterer Alkali- oder Erdalkalimetallhydroxids und anschließendem Entwässern auf die obengenannten Alkoxylatgehalte von 0,05 bis 50 Äquivalenz-% eingestellt. Solchermaßen hergestellte polymere Alkoxylate können separat unter Inertgasatmosphäre gelagert werden. Sie werden besonders dann bevorzugt verwendet, wenn die Menge an niedermolekularem Starter bei der Herstellung langkettiger Polyole nicht ausreichend ist, um zu Reaktionsbeginn eine ausreichende Durchmischung des Reaktionsgemisches zu gewährleisten. Ferner neigen bestimmte niedermolekulare Starter zur Bildung schwerlöslicher Alkali- oder Erdalkalimetallsalze; in solchen Fällen empfiehlt sich die vorgeschaltete Überführung des Starters nach dem oben geschilderten Verfahren in ein polymeres Alkoxylat ebenfalls. Die Menge des im erfindungsgemäßen Verfahren eingesetzten polymeren Alkoxylates wird üblicherweise so bemessen, dass sie einer auf die Menge des herzustellenden, erfindungsgemäßen Endproduktes bezogenen Alkali- oder Erdalkalimetallhydroxidkonzentration von 0,004 bis 0,8 Gew.-%, bevorzugt 0,004 bis 0,6 Gew.-% entspricht. Die polymeren Alkoxylate können natürlich auch als Gemische eingesetzt werden.

Geeignete Alkylenoxide sind beispielsweise Ethylenoxid, Propylenoxid, 1,2-Butylenoxid bzw. 2,3-Butylenoxid und Styroloxid. Bevorzugt werden Propylenoxid, Ethylenoxid und 1,2-Butylenoxid eingesetzt. Die Alkylenoxide können einzeln, im Gemisch oder blockweise dosiert werden. Produkte mit Ethylenoxidendblöcken sind beispielsweise durch erhöhte Konzentrationen an primären Endgruppen gekennzeichnet, welche den Systemen eine höhere Isocyanatreaktivität verleihen.

Ein weiteres Verfahren zur Herstellung der als Komponente B1) eingesetzten Polyole erfolgt über den Einsatz von DMC-Katalysatoren. Bevorzugt eingesetzt werden verbesserte, hochaktive DMC-Katalysatoren, die z.B. beschrieben sind in US-A 5 470 813, EP-A 700 949, EP-A 743 093, EP-A 761 708, WO 97/40086, WO 98/16310 und WO 00/47649. Ein typisches Beispiel sind die in EP-A 700 949 beschriebenen hochaktiven DMC-Katalysatoren, die neben einer Doppelmetallcyanid-Verbindung (z.B. Zinkhexacyanocobaltat(III)) und einem organischen Komplexliganden (z.B. tert.-Butanol) noch einen Polyether mit zahlenmittlerem Molekulargewicht größer als 500 g/Mol enthalten.

Als Alkylenoxide kommen bevorzugt Ethylenoxid, Propylenoxid, Butylenoxid sowie deren Mischungen zum Einsatz. Der Aufbau der Polyetherketten durch Alkoxylierung kann z.B. nur mit einem monomeren Epoxid durchgeführt werden oder auch statistisch oder blockweise mit 2 oder 3 unterschiedlichen monomeren Epoxiden erfolgen. Näheres ist "Ullmanns Encyclopädie der industriellen Chemie", englisch-sprachige Ausgabe, 1992, Band A21, Seiten 670 - 671, zu entnehmen.

Als aktive Wasserstoffatome aufweisende Starterverbindungen werden vorzugsweise Verbindungen mit Molekulargewichten von 18 bis 2000 g/Mol und 1 bis 8 Hydroxylgruppen eingesetzt. Beispielsweise werden genannt: Ethylenglykol, Diethylenglykol, Triethylenglykol, 1,2-Propylenglykol, 1,4-Butandiol, Hexamethylenglykol, Bisphenol A, Trimethylolpropan, Glycerin, Pentaerythrit, Sorbit, Rohrzucker, abgebaute Stärke oder Wasser.

Vorteilhafterweise werden solche aktive Wasserstoffatome aufweisende Starterverbindungen eingesetzt, die z.B. durch konventionelle Alkalikatalyse aus den zuvor genannten niedermolekularen Startern hergestellt wurden und oligomere Alkoxylierungsprodukte darstellen mit Molekulargewichten von 200 bis 2000 g/Mol.

Die durch die nach dem erfindungsgemäßen Verfahren hergestellten DMC-Katalysatoren katalysierte Polyaddition von Alkylenoxiden an aktive Wasserstoffatome aufweisende Starterverbindungen erfolgt im allgemeinen bei Temperaturen von 20 bis 200°C, bevorzugt im Bereich von 40 bis 180°C, besonders bevorzugt bei Temperaturen von 50 bis 150°C. Die Reaktion kann bei Gesamtdrücken von 0 bis 20 bar durchgeführt werden. Die Polyaddition kann in Substanz oder einem inerten, organischen Lösungsmittel, wie Toluol und/oder THF, durchgeführt werden. Die Menge an Lösungsmittel beträgt üblicherweise 10 bis 30 Gew.-%, bezogen auf die Menge des herzustellenden Polyetherpolyols.

Ebenfalls geeignet als Polyetherpolyole B1) sind Trimethylenoxide gemäß Formel (III), die wie in US 2002/07043 A1 und 2002/10374 A1 beschrieben durch säure-katalysierte Polykondensation von 1,3-Propandiol oder aber wie in J. Polym. Sci, Polym. Chem. Ed. 28 (1985), p. 444-449 durch ringöffnende Polymerisation von cyclischen Ethern zugänglich sind.

In B1) können Verbindungen des gleichen Typs oder auch Mischungen mehrerer verschiedener Verbindungen eingesetzt werden, die jeweils das geforderte Strukturmerkmal aufweisen.

Bevorzugte erfindungswesentliche Polyetherpolyole B1) sind solche der vorgenannten Art ausschließlich basierend auf Propylenoxid oder statistische oder Block-Copolymere basierend auf Propylenoxid mit weiteren 1-Alkylenoxiden, wobei der 1-Alykenoxidanteil nicht höher als 80 Gew.-% ist. Daneben sind Poly(trimethylenoxid)e gemäß Formel (III) sowie Mischungen der als bevorzugt genannten Polyole bevorzugt. Besonders bevorzugt sind Propylenoxid-homopolymere sowie statistische oder Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen- umfasst hierbei alle jeweiligen linearen und verzweigten C3- und C4-Isomere.

Solche Polyetherpolyole B1) der vorgenannten Art haben bevorzugt mittlere OH-Funktionalitäten von 1,5 bis 6 und zahlenmittleren Molekulargewichte von 1000 bis 18500 g/Mol, besonders bevorzugt OH-Funktionalitäten von 1,8 bis 4,0 und zahlenmittleren Molekulargewichte von 1000 bis 8500 g/Mol und ganz besonders bevorzugt OH-Funktionalitäten von 1,9 bis 3,1 und zahlenmittleren Molekulargewichte von 1000 bis 6500 g/Mol.

Solche Polyetherpolyole B1) der vorgenannten Art haben bevorzugt einen Brechungsindex $n_D^{20}$ < 1,55, besonders bevorzugt < 1,50 und ganz besonders bevorzugt < 1,47.

Als weitere Bestandteile der isocyanatreaktiven Komponente B) können alle dem Fachmann bekannten OH- und/oder NH-funktionellen Verbindungen als B2) eingesetzt werden. Dies sind insbesondere di- und höherfunktionelle Polyetherpolyole, die nicht der Formel (I) bis (III) gehorchen, Polyesterpolyole, Polycarbonatpolyole, Homo- oder Mischpolymerisate von Lactonen, hydroxy- oder aminfunktionelle Polyacrylharze und Polyamine wie z.B. die Jeffamine® oder andere aminterminierte Polymere sowie deren (Block-)Copolymere oder Mischungen.

Werden in B) Mischungen von B1) und B2) eingesetzt, so wird bevorzugt mindestens 80 Gew.-% B1) und höchstens 20 Gew.-% B2), besonders bevorzugt mindestens 99 Gew.-% B1) und höchstens 1 Gew.-% B2) und ganz besonders bevorzugt 100 Gew.-% B1) eingesetzt.

Bevorzugt werden in C) Verbindungen mit einem Brechungsindex $n_D^{20}$ > 1,55, besonders bevorzugt > 1,58 eingesetzt.

In Komponente C) können Verbindungen wie $\alpha,\beta$-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, $\alpha$-Methylstyrol, Vinyltoluol, Olefinine, wie z.B. 1-Octen und/oder 1-Decen, Vinylestern, (Meth)acrylnitril, (Meth)acrylamid, Methacrylsäure, Acrylsäure eingesetzt werden. Bevorzugt sind Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p-Chlorphenylacrylat, p-Chlorphenylmethacrylat, p-Bromphenylacrylat, p-Bromphenylmethacrylat, 2,4,6-Trichlorphenylacrylat, 2,4,6-Trichlorphenylmethacrylat, 2,4,6-Tribromphenylacrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxyl}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate um nur eine Auswahl verwendbarer Acrylate und Methacrylate zu nennen.

Selbstverständlich können auch Urethanacrylate als Komponente C) verwendet werden. Unter Urethanacrylaten versteht man Verbindungen mit mindestens einer Acrylsäureestergruppe die zusätzlich über mindestens eine Urethanbindung verfügen. Es ist bekannt, dass solche Verbindungen durch Umsetzung eines Hydroxy-funktionellen Acrylsäureesters mit einer Isocyanat-funktionellen Verbindung erhalten werden können.

Beispiele hierfür verwendbarer Isocyanate sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)oktan, 2,2,4- und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise in Betracht Verbindungen wie 2-Hydroxyethyl(meth)acrylat, Polyethylenoxid-mono(meth)acrylate, Polypropylenoxidmono(meth)acrylate, Polyalkylenoxidmono-(meth)acrylate, Poly($\varepsilon$-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-di-methylpropyl(meth)acrylat, Hydroxypropyl(meth)acrylat, Acrylsäure-(2-hydroxy-3-phenoxy-propylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly($\varepsilon$-caprolacton)mono(meth)acrylate. Darüberhinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten. Bevorzugt sind hydroxylgruppenhaltige Epoxyacrylate mit definierter Hydroxyfunktionalität. Hydroxylguppenhaltige Epoxy(meth)acrylate basieren insbesondere auf Umsetzungsprodukten von Acrylsäure und/oder Methacrylsäure mit Epoxiden (Glycidylverbindungen) von monomeren, oligomeren oder polymeren Bisphenol-A, Bisphenol-F, Hexandiol und/oder Butandiol oder deren ethoxylier-ten und/oder propoxylierten Derivaten. Bevorzugt sind weiterhin Epoxyacrylate mit definierter Funktionalität wie sie aus der bekannten Umsetzung von Acrylsäure und/oder Methacrylsäure und Glycidyl(meth)acrylat erhalten werden können.

Bevorzugt werden (Meth-)Acrylate und/oder Urethan(meth-)acrylate verwendet, besonders bevorzugt (Meth-)Acrylate und/oder Urethan(meth-)acrylate die mindestens eine aromatische Struktureinheit aufweisen.

Besonders bevorzugte als Komponente C zu verwendende Verbindungen sind Urethanacrylate und Urethanmethacrylate auf Basis aromatischer Isocyanate und 2-Hydroxyethylacrylat, Hydroxypropylacrylat, 4-Hydroxybutylacrylat, Polyethylenoxid-mono(meth)acrylat, Polypropylenoxid-mono(meth)acrylat, Polyalkylenoxidmono(meth)acrylat und Poly($\varepsilon$-caprolacton)mono(meth)-acrylate.

In einer ganz besonders bevorzugten Ausführungsform werden als Komponente C die Additionsprodukte aromatischer Triisocyanate (ganz besonders bevorzugt Tris-(4-phenylisocyanato)-thiophosphat oder Trimere aromatischer Diisocyanate wie Toluylendiisocyanat) mit Hydroxyethylacrylat, Hydroxypropylacrylat, 4-Hydroxybutylacrylat eingesetzt. In einer weiteren ganz besonders bevorzugten Ausführungsform werden als Komponente C Additionsprodukte von 3-Thiomethyl-phenylisocyanat mit Hydroxyethylacrylat, Hydroxypropylacrylat, 4-Hydroxy-butylacrylat eingesetzt

Beispiele für Vinylaromaten sind Styrol, halogenierte Derivate von Styrol wie z.B. 2-Chlorstyrol, 3-Chlorstyrol, 4-Chlorstyrol, 2-Bromstyrol, 3-Bromstyrol, 4-Bromstyrol, p-(Chlormethyl)styrol, p-(Brommethyl)styrol oder 1-Vinylnaphthalin, 2-Vinylnaphthalin, 2-Vinylantracen, 9-Vinylanthracen, 9-Vinylcarbazol oder difunktionelle Verbindungen wie Divinylbenzol.

Als Verbindungen der Komponente D) geeignet sind beispielsweise Inhibitoren und Antioxidantien wie sie z.B. in "Methoden der organischen Chemie" (Houben-Weyl), 4. Auflage, Band XIV/1, S. 433ff, Georg Thieme Verlag, Stuttgart 1961, beschrieben sind. Geeignete Stoffklassen sind beispielsweise Phenole wie z.B. 2,6-Di-tert-butyl-4-methylphenol, Kresole, Hydrochinone, Benzylalkohole wie z.B. Benzhydrol, ggf. auch Chinone wie z. B. 2,5-Di-*tert*.-Butylchinon, ggf. auch aromatische Amine wie Diisopropylamin oder Phenothiazin.

Bevorzugt sind 2,6-Di-*tert*.-butyl-4-methylphenol, Phenothiazin, p-Methyoxyphenol, 2-Methoxy-p-hydrochinon und Benzhydrol.

Als Komponente E) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethyl-benzoyl-diphenylphosphinoxid, Bisacylophosphinoxid, Phenylglyoxylsäureester, Campherchinon, alpha-Aminoalkylphenon, alpha-,alpha-Dialkoxyacetophenon, 1-[4-(Phenylthio)phenyl]octan-1,2-dion-2-(O-benzoyloxim) und alpha-Hydroxyalkylphenon. Auch die in EP-A 0223587 beschriebenen Photoinitiatorsysteme bestehend aus einer Mischung aus einem Ammoniumarylborat und einem oder mehreren Farbstoffen können als Photoinitiator eingesetzt werden. Als Ammoniumarylborat eignen sich beispielsweise Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat. Als Farbstoffe eignen sich beispielsweise Neu-Methylenblau, Thionin, Basic Yellow, Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29, Pyrillium I, Cyanin und Methylenblau, Azur A (Cunningham et al., RadTech'98 North America UV/EB Conference Proceedings, Chicago, Apr. 19-22, 1998).

Die für die anionische Polymerisation verwendeten Photoinitiatoren sind in der Regel (Typ I)-Systeme und leiten sich von Übergangsmetall-Komplexen der ersten Reihe ab. Hier sind ChromSalze, wie z.B. trans-$Cr(NH_3)_2(NCS)_4^-$ (Kutal et al, Macromolecules 1991, 24, 6872) oder Ferrocenyl-Verbindungen (Yamaguchi et al. Macromolecules 2000, 33, 1152) bekannt. Eine weitere Möglichkeit der anionischen Polymerisation besteht in der Verwendung von Farbstoffen, wie Kristallviolett Leukonitril oder Malchit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut, so dass die resultierenden Polymere durchgefärbt sind.

Die für die kationische Polymerisation verwendeten Photoinitiatoren bestehen im wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch in Abwesenheit eines Wasserstoff-Donors ein Kation erzeugten, dass die Polymerisation initiiert. Die Effizienz des Gesamtsystems wird durch die Natur des verwendeten Gegenions zur Diazonium-Verbindung bestimmt. Bevorzugt sind hier die wenig reaktiven aber recht teuren $SbF_6^-$, $AsF_6^-$ oder $PF_6^-$. Für den Einsatz in Beschichtung dünner Filme sind diese Verbindungen i.d.R wenig geeignet, da durch den nach der Belichtung freigesetzten Stickstoff die Oberflächegüte herabgesetzt wird (pinholes) (Li et al., Polymeric Materials Science and Engineering, 2001, 84, 139). Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalkation, welches sich durch H-Abstraktion stabilisiert, ein Proton freisetzt und dann die kationische Polymerisation startet (Dektar et al. J. Org. Chem. 1990, 55, 639; J. Org. Chem., 1991, 56, 1838). Dieser Mechanismus ermöglicht den Einsatz von Iodonium-Salzen ebenfalls für die radikalische Photopolymerisation. Hierbei kommt erneut der Wahl des Gegenions eine große Bedeutung zu, bevorzugt werden ebenfalls die recht teuren $SbF_6^-$, $AsF_6^-$ oder $PF_6^-$. Ansonsten ist in dieser Strukturklasse die Wahl der Substitution des Aromaten recht frei und im wesentlichen durch die Verfügbarkeit geeigneter Startbausteine für die Synthese bestimmt. Bei den Sulfonium-Salzen handelt es sich um Verbindungen, die nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6^-$ Salzen erzielt. Da die Eigenabsorption von Iodonium- und Sulfonium-Salze bei <300nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivaten (Hua et al, Macromolecules 2001, 34, 2488-2494).

Es kann vorteilhaft sein auch Gemische dieser Verbindungen einzusetzen. Je nach zur Härtung verwendeter Strahlungsquelle muss Typ und Konzentration an Photoinitiator in dem Fachmann bekannter Weise angepasst werden. Die vorgenannte Einstellung hinsichtlich der Photopolymerisation ist für einen Fachmann in Form von Routineversuchen innerhalb der unten angegebenen Mengenbereiche der Komponenten sowie der jeweils zur Auswahl stehenden, insbesondere den bevorzugten Aufbaukomponenten, leicht möglich.

Bevorzugte Photoinitiatoren E) sind Mischungen aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Als Verbindungen der Komponente F) können gegebenenfalls ein oder mehrere Katalysatoren eingesetzt werden. Dabei handelt es sich um Katalysatoren zur Beschleunigung der Urethanbildung. Bekannte Katalysatoren hierfür sind beispielsweise Zinnoctoat, Zinkoktoat, Dibutylzinndilaurat, Dimethylbis[(1-oxoneodecyl)oxy]stannan, Dimethylzinndicarboxylat, Zirkonium-bis(ethylhexanoat), Zirconium-acteylacetonat oder tertiäre Aminen wie beispielsweise 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Bevorzugt sind Dibutylzinndilaurat, Dimethylbis[(1-oxoneodecyl)oxy]stannan, Dimethylzinndicarboxylat, 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Selbstverständlich können gegebenenfalls weitere Zusatzstoffe G) eingesetzt werden. Dabei kann es sich beispielsweise um im Bereich der Lacktechnologie gängige Zusatzstoffe wie Lösemittel, Weichmacher, Verlaufsmittel oder Haftvermittler handeln. Als Weichmacher werden dabei bevorzugt Flüssigkeiten mit guten Löseeigenschaften, geringer Flüchtigkeit und hoher Siedetemperatur eingesetzt. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Mit den erfindungsgemäßen Polyurethanzusammensetzungen können durch entsprechende Belichtungsprozesse Hologramme für optische Anwendungen im gesamten sichtbaren Bereich sowie im nahen UV-Bereich (300 - 800 nm) hergestellt werden. Visuelle Hologramme umfassen alle Hologramme, die nach dem Fachmann bekannten Verfahren aufgezeichnet werden können, darunter fallen unter anderem In-Line (Gabor) Hologramme, Off-Axis Hologramme, Full-Aperture Transfer Hologramme, Weißlicht-Transmissionshologramme ("Regenbogenhologramme"), Denisyukhologramme, Off-Axis Reflektionshologramme, Edge-Lit Hologramme sowie Holographische Stereogramme, bevorzugt sind Reflexionshologramme, Denisyukhologramme, Transmissionshologramme. Bevorzugt sind optische Elemente wie Linsen, Spiegel, Umlenkspiegel, Filter, Streuscheiben, Beugungselemente, Lichtleiter, Lichtlenker (waveguides), Projektionsscheiben und/oder Masken haben. Häufig zeigen diese optischen Elemente eine Frequenzselektivität je nachdem wie die Hologramme belichtet wurden und welche Dimensionen das Holgramm hat. Die beschriebenen Polyurethanzusammensetzungen sind deswegen besonders vorteilhaft, da bei ihrer Anwendung ein hoher Brechungsindexkontrast Delta $n \geq 0.011$ zu erreichen ist, der mit den im Stand der Technik beschriebenen Formulierungen nicht erreicht wird.

Zudem können mittels der erfindungsgemäßen Polyurethanzusammensetzungen auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

Ein weiterer Gegenstand der vorliegenden Erfindung ist daher die Verwendung der erfindungsgemäßen Medien zur Aufzeichnung visueller Hologramme, zur Herstellung von optischen Elementen, Bildern, Darstellungen sowie ein Verfahren zur Aufzeichnung von Hologrammen unter Verwendung der erfindungsgemäßen Polyurethanzusammensetzungen und den daraus zugänglichen Medien oder holografischen Filmen.

Das erfindungsgemäße Verfahren zur Herstellung von holografischen Medien zur Aufzeichnung visueller Hologramme wird bevorzugt derart durchgeführt, dass die Aufbaukomponenten der erfindungsgemäßen Polyurethanzusammensetzungen mit Ausnahme der Komponente A) miteinander homogen vermischt werden und unmittelbar vor der Applikation auf das Substrat oder in die Form erst Komponente A) zugemischt wird.

Zur Vermischung können alle dem Fachmann aus der Mischungstechnik an sich bekannten Verfahren und Apparate, wie beispielsweise Rührkessel oder sowohl dynamische als auch statische Mischer verwendet werden. Bevorzugt sind allerdings Apparate ohne oder mit nur geringen Toträumen. Weiterhin sind Verfahren bevorzugt, in denen die Vermischung innerhalb sehr kurzer Zeit und mit sehr starker Durchmischung der beiden zu mischenden Komponenten erfolgt. Hierfür eignen sich insbesondere dynamische Mischer, insbesondere solche, in denen die Komponenten erst im Mischer miteinander in Kontakt kommen.

Die Temperaturen betragen dabei 0 bis 100 °C, bevorzugt 10 bis 80 °C, besonders bevorzugt 20 bis 60 °C.

Falls notwendig kann auch eine Entgasung der einzelnen Komponenten oder der gesamten Mischung unter einem reduzierten Druck von beispielsweise 1 mbar durchgeführt werden. Ein Entgasen, insbesondere nach Zugabe der Komponente A) ist bevorzugt, um Blasenbildung durch Restgase in den erhältlichen Medien zu verhindern.

Vor Zumischung der Komponente A) können die Mischungen als lagerstabiles Zwischenprodukt gegebenenfalls über mehrere Monate gelagert werden kann.

Nach der Zumischung der Komponente A) der erfindungsgemäßen Polyurethanzusammensetzungen wird eine klare, flüssige Formulierung erhalten, die je nach Zusammensetzung bei Raumtemperatur innerhalb weniger Sekunden bis zu einigen Stunden aushärtet.

Das Verhältnis sowie die Art und Reaktivität der Aufbaukomponenten der Polyurethanzusammensetzungen wird bevorzugt so eingestellt, dass die Aushärtung nach Zumischung der Komponente A) bei Raumtemperatur innerhalb von Minuten bis zu einer Stunde eintritt. In einer bevorzugten Ausführungsform wird die Aushärtung beschleunigt indem die Formulierung nach der Zumischung auf Temperaturen zwischen 30 und 180 °C, bevorzugt 40 bis 120 °C, besonders bevorzugt 50 bis 100 °C erwärmt wird.

Die vorgenannte Einstellung hinsichtlich des Aushärteverhaltens ist für einen Fachmann leicht in Form von Routineversuchen innerhalb der oben angegebenen Mengenbereich der Komponenten sowie der jeweils zur Auswahl stehenden, insbesondere den bevorzugten Aufbaukomponenten, leicht möglich.

Die erfindungsgemäßen Polyurethanzusammensetzungen besitzen unmittelbar nach vollständiger Vermischung aller Komponenten Viskositäten bei 25°C von typischerweise 10 bis 100000 mPas, bevorzugt 100 bis 20000 mPas, besonders bevorzugt 200 bis 10000 mPas, insbesondere bevorzugt 500 bis 5000 mPas so dass sie bereits in lösemittelfreier Form sehr gute verarbeitungstechnische Eigenschaften besitzen. In Lösung mit geeigneten Lösemitteln können Viskositäten bei 25°C unterhalb 10000 mPas, bevorzugt unterhalb 2000 mPas, besonders bevorzugt unterhalb 500 mPas eingestellt werden.

Als vorteilhaft haben sich Polyurethanzusammensetzungen der vorstehend genannten Art erwiesen, die in einer Menge von 15 g und mit einem Katalysatorgehalt von 0,004 Gew.-% bei 25°C unter 4 Stunden aushärten, bzw. bei einem Katalysatorgehalt von 0,02 % in weniger als 10 Minuten bei 25°C aushärten.

Zur Applikation auf ein Subtrat bzw. in eine Form sind alle jeweiligen gängigen, dem Fachmann bekannten Verfahren geeignet, wie insbesondere Rakeln, Gießen, Drucken, Siebdruck, Spritzen, oder Inkjet-Druck.

**Beispiele:**

Die folgenden Beispiele sind zur Erläuterung der erfindungsgemäßen Photopolymere genannt, sollen aber nicht als begrenzend verstanden sein. Sofern nicht abweichend vermerkt beziehen sich alle Prozentangaben auf Gewichtsprozent.

Desmodur® XP 2410 ist ein Versuchsprodukt der Bayer MaterialScience AG, Leverkusen, DE, Hexandiisocyanat-basiertes Polyisocyanat, Anteil an Iminooxadiazindion mindestens 30 %, NCO-Gehalt: 23,5 %

Desmodur® XP 2599 ist ein Versuchsprodukt der Bayer MaterialScience AG, Leverkusen, DE, Vollallophanat von Hexandiisocyanat auf Acclaim 4200, NCO-Gehalt: 5,6 - 6,4 %

Desmodur® XP 2580 ist ein Versuchsprodukt der Bayer MaterialScience AG, Leverkusen, DE, aliphatisches Polyisocyanat auf Basis von Hexandiisocyanat, NCO-Gehalt ca. 20 %

Terathane® 1000 ist ein Handelsprodukt der Fa. BASF SE, Ludwigshafen, DE (Poly-THF der zahlenmittleren Molmasse 1000 g/Mol).

Polyol 2 ist ein difunktionelles Poly($\epsilon$-Caprolacton)-polyols (zahlenmittlere Molmasse ca. 650 g/Mol).

Alle anderen Polyole sind Handelsprodukte der Fa. Bayer MaterialScience AG, Leverkusen, DE und deren Zusammensetzung ist in den Beispielen bei Nennung beschrieben.

Fomrez® UL28: Urethanisierungskatalysator, Dimethylbis[(1-oxoneodecl)oxy]stannan, Handelsprodukt der Fa. Momentive Performance Chemicals, Wilton, CT, USA (als 10%ige Lösung in N-Ethylpyrrolidon eingesetzt).

CGI 909 ist ein im Jahr 2008 von der Fa. Ciba Inc., Basel, Schweiz vertriebenes Versuchsprodukt.

Messung von Beugungswirkungsgrad DE und Brechungsindexkontrast Δn:

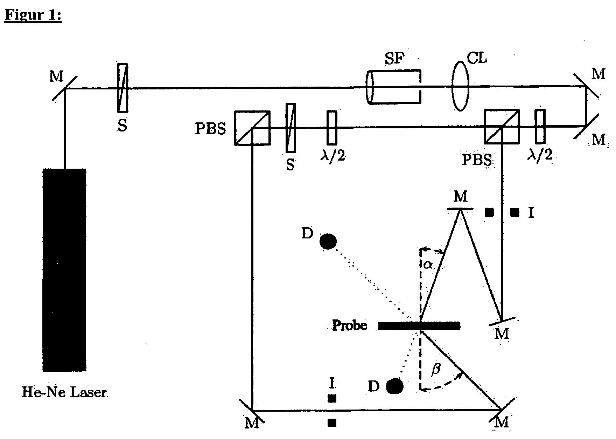

Die im Rahmen des experimentellen Teils hergestellten erfindungsgemäßen und Vergleichsmedien wurden mittels einer Messanordnung gemäß Figur 1 auf ihre holographischen Eigenschaften geprüft:

Figur 1: Geometrie eines Holographie Media Testers bei λ = 633 nm (He-Ne Laser)zum Schreiben eines Reflexionshologrammes: M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, I = Irisblende, α = 21.8° und β = 41.8° sind die Einfallswinkel der kohärenten Strahlen ausserhalb der Probe (des Mediums) gemessen.

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 4 mm. Die polarisationsabhängigen Strahlteiler (PBS) teilen den Laserstrahl in zwei kohärente gleich polarisierte Strahlen. Über die $\lambda/2$ Plättchen wurden die Leistung des Referenzstrahls of 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel (α) des Referenzstrahls beträgt 21.8°, der Einfallswinkel (β) des Signalstrahls beträgt 41.8°. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand im Medium beträgt ~ 225 nm (Brechungsindex des Mediums zu ~1.49 angenommen).

Es wurden auf folgende Weise Hologramme in das Medium geschrieben:

Beide Shutter (S) sind für die Belichtungszeit t geöffnet. Danach wurde bei geschlossenen Shuttern (S) dem Medium 5 Minuten Zeit für die Diffusion der noch nicht polymerisierten Schreibmonomere gelassen. Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel (Ω) des Mediums der Strahl immer vollständig im zuvor geschriebenen Hologramm lag. Der Drehtisch überstrich nun computergesteuert den Winkelbereich von Ω = 0° bis Ω = 20° mit einer Winkelschrittweite von 0.05°. An jedem angefahrenen Winkel wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz η ergab sich bei jedem angefahrenen Winkel Ω als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad η in Abhängigkeit des Drehwinkels Ω des geschriebenen Hologramms gemessen und in einem Computer gespeichert. Zusätzlich wurde auch die in die nullte Ordnung transmittierte Intensität gegen der Drehwinkel Ω aufgezeichnet und in einem Computer gespeichert.

Die maximale Beugungseffizienz (DE = $\eta_{max}$) des Hologramms, also sein Spitzenwert, wurde ermittelt. Eventuell musste dazu die Position des Detektors des abgebeugten Strahls verändert werden, um diesen maximalen Wert zu bestimmen.

Der Brechungsindexkontrast Δn und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Das Verfahren wird im folgenden beschrieben:

Für die Braggkurve η/(Ω) eines Reflexionshologramms gilt nach Kogelnik:

$$\eta = \cfrac{1}{1 + \cfrac{1-(\chi/\Phi)^2}{\sinh^2\left(\sqrt{\Phi^2-\chi^2}\right)}}$$

mit:

$$\Phi = \frac{\pi \cdot \Delta n \cdot d}{\lambda \cdot \sqrt{\cos(\alpha') \cdot \cos(\alpha'-2\psi)}}$$

$$\chi = \Delta\theta \cdot \frac{2\pi \cdot \sin(\alpha'-\psi)}{\Lambda \cdot \cos(\alpha'-2\psi)} \cdot \frac{d}{2}$$

$$\psi = \frac{\beta'-\alpha'}{2}$$

$$\Lambda = \frac{\lambda}{2 \cdot n \cdot \cos(\psi - \alpha')}$$

$$n \cdot \sin(\alpha') = \sin(\alpha), \, n \cdot \sin(\beta') = \sin(\beta)$$

$$\Delta\theta = -\Delta\Omega \cdot \sqrt{\frac{1-\sin^2(\alpha)}{n^2-\sin^2(\alpha)}}$$

$\Phi$ ist die Gitterstärke, $\chi$ ist der Detuning Parameter und $\psi$ der Kippwinkel des Brechungsindexgitters, das geschrieben wurde. $\alpha'$ und $\beta'$ entsprechen den Winkeln $\alpha$ und $\beta$ beim Schreiben des Hologramms, aber im Medium. $\Delta\Theta$ ist das Winkeldetuning gemessen im Medium, also die Abweichung vom Winkel $\alpha'$. $\Delta\Omega$ ist das Winkeldetuning gemessen außerhalb des Mediums, also die Abweichung vom Winkel $\alpha$. n ist der mittlere Brechungsindex des Photopolymers und wurde zu 1.504 gesetzt.

Die maximale Beugungseffizienz (DE = $\eta_{max}$) ergibt sich dann für $\chi = 0$, also $\Delta\Omega = 0$ zu:

$$DE = \tanh^2(\Phi) = \tanh^2\left(\frac{\pi \cdot \Delta n \cdot d}{\lambda \cdot \sqrt{\cos(\alpha') \cdot \cos(\alpha'-2\psi)}}\right)$$

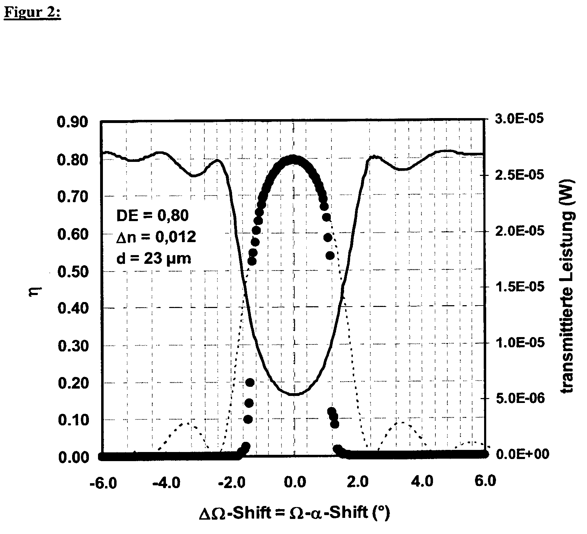

Die Messdaten der Beugungseffizienz, die theoretische Braggkurve und die transmittierte Intensität werden wie in Figure 2 gezeigt gegen den zentrierten Drehwinkel $\Omega$-$\alpha$-Shift aufgetragen. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Da DE bekannt ist wird die Form der theoretischen Braggkurve nach Kogelnik nur noch durch die Dicke d der Photopolymerschicht bestimmt. $\Delta n$ wird über DE für gegebene Dicke d so nachkorrigiert, dass Messung und Theorie von DE immer übereinstimmen. d wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für theoretische Braggkurve und die transmittierte Intensität übereinstimmen.

Da die Richtung in der ein Reflexionshologramm bei der Rekonstruktion mittels eines $\Omega$-Scans mitrotiert, der Detektor für das abgebeugte Licht aber nur einen endlichen Winkelbereich erfassen kann, wird die Braggkurve von breiten Hologrammen (kleines d) bei einem $\Omega$-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke d zusätzlich herangezogen.

Figur 2: Darstellung der Braggkurve η nach Kogelnik (gestrichelte Linie), des gemessenen Beugungswirkungsgrades (ausgefüllte Kreise) und der transmittierten Leistung (schwarz durchgezogene Linie) gegen das Winkeldetuning $\Delta\Omega$. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt:

$$E\,(\mathrm{mJ/cm^2}) = \frac{2\cdot\left[0.50\,\mathrm{mW} + 0.67\,\mathrm{mW}\right]\cdot t\,(\mathrm{s})}{\pi\cdot 0.4^2\,\mathrm{cm^2}}$$

Die Leistungen der Teilstrahlen wurden so angepasst, dass in dem Medium bei den verwendeten Winkeln $\alpha$ und $\beta$, die gleiche Leistungsdichte erreicht wird.

Herstellung von Polyol 1

In einem 1 L Kolben wurden 0.18 g Zinnoktoat, 374.8 g $\varepsilon$-Caprolacton und 374.8 g eines difunktionellen Polytetrahydrofuranpolyetherpolyols (Terathane® 1000, Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

Herstellung des Urethanacrylates 1

In einem 500 mL Rundkolben wurden 0.1 g 2,6-Di-tert.-butyl-4-methylphenol, 0.05 g Dibutylzinndilaurat (Desmorapid Z, Bayer MaterialScience AG, Leverkusen, Deutschland) sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

Zur Herstellung der holografischen Medien werden die Komponente C, die Komponente D (die bereits in der Komponente C vorgelöst sein kann) sowie gegebenenfalls die Komponente G in der Komponente B gegebenenfalls bei 60 °C gelöst, dann werden Glasperlen der Größe 20 $\mu$m (z. B. der Fa. Whitehouse Scientific Ltd, Waverton, Chester, CH3 7PB, United Kingdom) zugegeben und gründlich gemischt. Danach wird im Dunklen oder unter geeigneter Beleuchtung die Komponente E in reiner Form oder in verdünnter Lösung in NEP zugewogen und im erneut 1 Minute gemischt. Gegebenenfalls wird maximal 10 Minuten im Trockenschrank auf 60 °C erhitzt. Dann wird Komponente A zugegeben und wieder im 1 Minute gemischt. Im Folgenden wird eine Lösung der Komponente F zugegeben und im erneut 1 Minute gemischt. Die erhaltene Mischung wird unter Rühren bei < 1 mbar maximal 30 Sekunden entgast, dann wird sie auf Glasplatten von 50 x 75 mm verteilt und diese je mit einer weiteren Glasplatte abgedeckt. Die Härtung der PU-Formulierung erfolgt unter 15 kg Gewichten über mehrere Stunden (gewöhnlich über Nacht). Teilweise werden die Medien in lichtdichter Verpackung noch 2 Stunden bei 60 °C nachgehärtet. Die Dicke d der Photopolymerschicht ergibt sich aus dem Durchmesser der verwendeten Glaskugeln zu 20 $\mu$m. Da unterschiedliche Formulierungen mit unterschiedlicher Ausgangsviskosität und unterschiedlicher Härtungsgeschwindigkeit der Matrix zu nicht immer gleichen Schichtdicken d der Photopolymerschicht führten, wird d anhand der Charakteristika der geschriebenen Hologramme für jede Probe separat ermittelt.

**Vergleichsbeispiel 1 (Medium):**

8.89 g der wie oben beschrieben hergestellten Polyol 1 (Vergleich für Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 1.647 g Desmodur® XP 2410 (Komponente A) zugegeben und erneut gemischt. Schließlich wurden 0.009 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Probenkörper wurde bei Raumtemperatur liegen gelassen und über 16 Stunden gehärtet. Maximaler Δn: 0,0101.

**Vergleichsbeispiel 2 (Medium):**

6.117 g des Polyol 2 (Vergleich für Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 4.418 g Baytec® WE 180 (Komponente A) zugegeben und erneut gemischt. Schließlich wurden 0.030 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0.0063.

**Vergleichsbeispiel 3 (Medium):**

7.342 g Terathane 1000 (Vergleich für Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 3.193 g Desmodur® XP 2580 (Komponente A) zugegeben und erneut gemischt. Schließlich wurden 0.030 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0,0106.

**Vergleichsbeispiel 4 (Medium):**

7.726 g Acclaim® 1000 (Polypropylenoxid der zahlenmittleren Molmasse 1000 g/Mol) (Vergleich für Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 2.809 g Desmodur® XP 2410 (Komponente A) zugegeben und erneut gemischt. Schließlich wurden 0.0309 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0,0065.

**Vergleichsbeispiel 5 (Medium):**

1.129 g Polyether L800 (Polypropylenoxid der zahlenmittleren Molmasse 200 g/Mol) (Vergleich für Komponente B) wurden mit 3.081 g Urethanacrylat 1 (Komponente C), 0.12 g CGI 909 und 0.012 g Neu Methylenblau (zusammen Komponente E) bei 60 °C und 0.431 g N-Ethylpyrilidon (Komponente G) gemischt, so dass eine klare Lösung erhalten wurde. Anschließend wurde auf 30 °C abgekühlt, 7.525 g Desmodur® XP 2599 (Komponente A) zugegeben und erneut gemischt. Schließlich wurden 0.0259 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0,0096.

**Beispiel 1 (Medium):**

7.743 g Acclaim® 4200 (Polypropylenoxid der zahlenmittleren Molmasse 4000 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 2.792 g Desmodur® XP 2599 (Komponente A) zugegeben und erneut gemischt. Schließlich wurden 0.0245 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0.0158.

**Beispiel 2 (Medium):**

7.264 g Polyether V 3970 (trifunktioneller, auf Glycerin gestarteter Mischpolyether aus Ethylen- und Propylenoxid mit gesamt 17.2 % Ethylenoxidanteil der zahlenmittleren Molmasse 4800 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 3.269 g Desmodur® XP 2599 (Komponente A) zugegeben und erneut gemischt. Schließlich wurden 0.0480 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Probenkörper wurde bei Raumtemperatur liegen gelassen und über 16 Stunden gehärtet. Maximaler $\Delta$n: 0.0120.

**Beispiel 3 (Medium):**

7.554 g Acclaim® 4220 N (ethylenoxid-gecapptes Polypropylenoxid der zahlenmittleren Molmasse 4000 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 2.983 g Desmodur® XP 2599 (Komponente A) zugegeben und erneut gemischt. Schließlich wurden 0.0071 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Probenkörper wurde bei Raumtemperatur liegen gelassen und über 16 Stunden gehärtet. Maximaler $\Delta$n: 0.0141.

**Beispiel 4 (Medium):**

6.081 g Desmophen® 2060 BD (Polypropylenoxid der zahlenmittleren Molmasse 2000 g/Mol, über KOH-Verfahren hergestellt) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 4.453 g Desmodur® XP 2599 (Komponente A) zugegeben und erneut gemischt. Schließlich wurden 0.0338 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Proben-körper wurde bei Raumtemperatur liegen gelassen und über 16 Stunden gehärtet. Maximaler $\Delta$n: 0.0137.

**Beispiel 5 (Medium):**

8.628 g Polyether L 5050 (difunktioneller Mischpolyether aus Ethylen- und Propylenoxid mit gesamt 50 % Ethylenoxidanteil des Equivalentgewichts 984,2 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 1.906 g Desmodur® XP 2580 (Komponente A) zugegeben und erneut gemischt. Schließlich wurden 0.0255 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Probenkörper wurde bei Raumtemperatur liegen gelassen und über 16 Stunden gehärtet. Maximaler $\Delta$n: 0.0150.

**Beispiel 6 (Medium):**

6.640 g Acclaim® 4200 (Polypropylenoxid der zahlenmittleren Molmasse 4000 g/Mol) (Komponente B) wurden mit 5.25 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 2.394 g Desmodur® XP 2599 (Komponente A) zugegeben und erneut gemischt. Schließlich wurden 0.0360 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Probenkörper wurde bei Raumtemperatur liegen gelassen und über 16 Stunden gehärtet. Maximaler $\Delta$n: 0.0205.

**Beispiel 7 (Medium):**

6.563 g Acclaim® 4200 (Polypropylenoxid der zahlenmittleren Molmasse 4000 g/Mol) (Komponente B) wurden mit 3.75 g Urethanacrylat 1 (Komponente C), 1.50 g Polyethylenglycol 250-monomethylether (Firma Sigma-Aldrich, Deutschland), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 2.472 g Desmodur® XP 2599 (Komponente A) zugegeben und erneut gemischt. Schließlich wurden 0.0302 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0.0200.

**Patentansprüche**

1. Polyurethanzusammensetzungen, umfassend

   A) eine Polyisocyanatkomponente,
   B) eine isocyanatreaktive Komponente umfassend zu mindestens 50 Gew.-% bezogen auf die Gesamtmenge von B) Polyetherpolyole B1) mit zahlenmittleren Molekulargewichten von größer 1000 g/Mol, die eine oder mehrere Oxyalkyleneinheiten der Formeln (I) bis (III) aufweisen

   $$-CH_2-CH_2-O- \qquad \text{Formel (I)}$$

   $$-CH_2-CH(R)-O- \text{ Formel} \qquad \text{(II)}$$

   $$-CH_2-CH_2-CH_2-O- \qquad \text{Formel (III)}$$

   wobei
   R ein Alkyl-, oder Arylrest, ist, der auch substituiert oder durch Heteroatome unterbrochen sein kann.
   C) Verbindungen, die unter Einwirkung aktinischer Strahlung mit ethylenisch ungesättigten Verbindungen unter Polymerisation reagierende Gruppen (strahlenhärtende Gruppen) aufweisen und selbst frei von NCO-Gruppen sind.
   D) Radikalstabilisatoren
   E) Photoinitiatoren
   F) gegebenenfalls Katalysatoren
   G) gegebenenfalls Hilfs- und Zusatzstoffe,
   **dadurch gekennzeichnet, dass** in C) Urethanacrylate und / oder Urethanmethacrylate eingesetzt werden.

2. Polyurethanzusammensetzungen gemäß Anspruch 1, **dadurch gekennzeichnet, dass** in A) Polyisocyanate und/oder Präpolymere basierend auf HDI, TMDI und/oder TIN eingesetzt werden.

3. Polyurethanzusammensetzungen gemäß Anspruch 1 oder 2, **dadurch gekennzeichnet, dass** in A) Polyisocyanate basierend auf HDI mit Isocyanurat- und/oder Iminooxadiazindionstrukturen oder Prepolymere mit NCO-Funktionalitäten von 2 bis 5, und ausschließlich primären NCO-Gruppen eingesetzt werden.

4. Polyurethanzusammensetzungen gemäß einem der Ansprüche 1 bis 3, **dadurch gekennzeichnet, dass** die in A) als Polyisocyanate eingesetzten Verbindungen Restgehalte an freiem monomerem Isocyanat von weniger als 0,5 Gew.-% aufweisen.

5. Polyurethanzusammensetzungen gemäß einem der Ansprüche 1 bis 4, **dadurch gekennzeichnet, dass** die in B1) eingesetzten Polyetherpolyole mittlere OH-Funktionalitäten 1,8 bis 4,0 und zahlenmittlere Molekulargewichte von 1000 bis 8500 g/Mol aufweisen.

6. Polyurethanzusammensetzungen gemäß einem der Ansprüche 1 bis 5, **dadurch gekennzeichnet, dass** in B1) Polyetherpolyole basierend auf Propylenoxid oder statistische oder Block-Copolymere basierend auf Propylenoxid mit weiteren 1-Alkylenoxiden mit einem 1-Alkenoxidanteil von nicht höher als 80 Gew.-% und/oder Poly(trimethylenoxid)e eingesetzt werden.

7. Polyurethanzusammensetzungen gemäß einem der Ansprüche 1 bis 6, **dadurch gekennzeichnet, dass** die in Komponente B1) eingesetzten Polyetherpolyole einen Brechungsindex $n_D^{20}$ < 1,55 aufweisen.

8. Polyurethanzusammensetzungen gemäß einem der Ansprüche 1 bis 7, **dadurch gekennzeichnet, dass** die in Komponente C) eingesetzten Verbindungen einen Brechungsindex $n_D^{20}$ > 1,55 aufweisen.

9. Polyurethanzusammensetzungen gemäß einem der Ansprüche 1 bis 8, **dadurch gekennzeichnet, dass** in Komponente C) Urethanacrylate und Urethanmethacrylate auf Basis aromatischer Isocyanate und 2-Hydroxyethylacrylat, Hydroxypropylacrylat, 4-Hydroxybutylacrylat, Polyethylenoxid-mono(meth)acrylat, Polypropylenoxidmono(meth)acrylat, Polyalkylenoxidmono-(meth)acrylat und Poly($\varepsilon$-caprolacton)mono(meth)acrylate eingesetzt werden.

10. Verfahren zur Herstellung von Medien zur Aufzeichnung visueller Hologramme, bei dem Polyurethanzusammensetzungen gemäß einem der Ansprüche 1 bis 9 auf ein Substrat oder in eine Form appliziert und ausgehärtet werden.

11. Medien zur Aufzeichnung visueller Hologramme erhältlich nach einem Verfahren gemäß Anspruch 10.

12. Verwendung von Medien gemäß Anspruch 11 als optische Elemente, Bilder oder zur Bilddarstellung oder -projektion.

13. Verfahren zur Aufzeichnung eines Hologramms, bei dem Medien gemäß Anspruch 12 eingesetzt werden.

**Claims**

1. Polyurethane compositions comprising

    A) a polyisocyanate component,
    B) an isocyanate-reactive component comprising at least 50% by weight, based on the total amount of B), of polyether polyols B1) with number average molecular weights greater than 1000 g/mol, which have one or more oxyalkylene units of the formulae (I) to (III),

    -CH$_2$-CH$_2$-O-              formula (I)

    -CH$_2$-CH(R)-O-              formula (II)

    -CH$_2$-CH$_2$-CH$_2$-O-              formula (III)

    in which
    R is an alkyl or aryl radical which may also be substituted or may be interrupted by heteroatoms
    C) compounds which have groups reacting under the action of actinic radiation with ethylenically unsaturated compounds with polymerization (radiation-curing groups) and are themselves free of NCO groups,
    D) free radical stabilizers
    E) photoinitiators
    F) optionally catalysts
    G) optionally auxiliaries and additives,
    **characterized in that** urethane acrylates and/or urethane methacrylates are used in C).

2. Polyurethane compositions according to Claim 1, **characterized in that** polyisocyanates and/or prepolymers based on HDI, TMDI and/or TIN are used in A).

3. Polyurethane compositions according to Claim 1 or 2, **characterized in that** polyisocyanates based on HDI with isocyanurate and/or iminooxadiazinedione structures or prepolymers having NCO functionalities of 2 to 5 and exclusively primary NCO groups are used in A).

4. Polyurethane compositions according to any of Claims 1 to 3, **characterized in that** the compounds used in A) as polyisocyanates have residual contents of free monomeric isocyanate of less than 0.5% by weight.

5. Polyurethane compositions according to any of Claims 1 to 4, **characterized in that** the polyether polyols used in B1) have average OH functionalities of 1.8 to 4.0 and number average molecular weights of 1000 to 8500 g/mol.

6. Polyurethane compositions according to any of Claims 1 to 5, **characterized in that** polyether polyols based on propylene oxide or random or block copolymers based on propylene oxide with further 1-alkylene oxides having a proportion of not higher than 80% by weight of 1-alkylene oxide and/or poly(trimethylene oxides) are used in B1).

7. Polyurethane compositions according to any of Claims 1 to 6, **characterized in that** the polyether polyols used in component B1) have a refractive index $n_D^{20} < 1.55$.

8. Polyurethane compositions according to any of Claims 1 to 7, **characterized in that** the compounds used in component C) have a refractive index $n_D^{20} > 1.55$.

9. Polyurethane compositions according to any of Claims 1 to 8, **characterized in that** urethane acrylates and urethane methacrylates based on aromatic isocyanates and 2-hydroxyethyl acrylate, hydroxypropyl acrylate, 4-hydroxybutyl acrylate, polyethylene oxide mono(meth)-acrylate, polypropylene oxide mono(meth)acrylate, polyalkylene oxide mono(meth)acrylate and poly($\varepsilon$-caprolactone) mono(meth)acrylates are used in component C).

10. Process for the production of media for recording visual holograms, in which polyurethane compositions according to any of Claims 1 to 9 are applied to a substrate or in a mould and are cured.

11. Media for recording visual holograms, obtainable by a process according to Claim 10.

12. Use of media according to Claim 11 as optical elements, images or for image representation or projection.

13. Method for recording a hologram, in which media according to Claim 12 are used.


**Revendications**

1. Compositions de polyuréthane comprenant

   A) un composant polyisocyanate,
   B) un composant réactif avec isocyanate, comprenant jusqu'à au moins 50 % en poids, rapportés à la quantité totale de B), de polyéther-polyols B1) avec des poids moléculaires numériques moyens supérieurs à 1000 g/mole, lesquels présentent une ou plusieurs unités d'oxyalkylène des formules (I) à (III),

   $$-CH_2-CH_2-O- \qquad \text{Formule (I)}$$

   $$-CH_2-CH(R)-O- \text{ Formule} \qquad \text{(II)}$$

   $$-CH_2-CH_2-CH_2-O- \qquad \text{Formule (III)}$$

   où
   R représente un radical alkyle ou aryle qui peut également être substitué ou interrompu par des hétéroatomes
   C) des composés qui présentent des groupes réagissant avec polymérisation sous l'effet d'un rayonnement actinique avec des composés éthyléniquement insaturés (groupes durcissant sous l'effet de rayons) et qui sont eux-mêmes exempts de groupes NCO
   D) des stabilisateurs de radicaux
   E) des photo-initiateurs
   F) le cas échéant des catalyseurs
   G) le cas échéant des adjuvants et des additifs, **caractérisées en ce qu'**on utilise dans C) des uréthane-acrylates et/ou des uréthane-méthacrylates.

2. Compositions de polyuréthane selon la revendication 1, **caractérisées en ce qu'**on utilise dans A) des polyisocyanates et/ou des prépolymères à base de HDI, de TMDI et/ou de TIN.

3. Compositions de polyuréthane selon la revendication 1 ou 2, **caractérisées en ce qu'**on utilise dans A) des polyisocyanates à base de HDI présentant des structures isocyanurate et/ou iminooxadiazinedione ou des prépolymères présentant des fonctionnalités NCO de 2 à 5 et exclusivement des groupes NCO primaires.

4. Compositions de polyuréthane selon l'une quelconque des revendications 1 à 3, **caractérisées en ce que** les composés utilisés dans A) comme polyisocyanates présentent des teneurs résiduelles en isocyanate monomère libre inférieures à 0,5% en poids.

5. Compositions de polyuréthane selon l'une quelconque des revendications 1 à 4, **caractérisées en ce que** les polyéther-polyols utilisés dans B1) présentent des fonctionnalités OH moyennes de 1,8 à 4, 0 et des poids moléculaires numériques moyens de 1000 à 8500 g/mole.

6. Compositions de polyuréthane selon l'une quelconque des revendications 1 à 5, **caractérisées en ce que** l'on utilise dans B1) des polyéther-polyols à base d'oxyde de propylène ou des copolymères statistiques ou à blocs à base d'oxyde de propylène avec des oxydes de 1-alkylène supplémentaires avec une proportion d'oxyde de 1-alkylène ne dépassant pas 80 % en poids, et/ou des poly(oxyde de triméthylène).

7. Compositions de polyuréthane selon l'une quelconque des revendications 1 à 6, **caractérisées en ce que** les polyéther-polyols utilisés dans le composant B1) présentent un indice de réfraction $n_d^{20} < 1,55$.

8. Compositions de polyuréthane selon l'une quelconque des revendications 1 à 7, **caractérisées en ce que** les composés utilisés dans le composant C) présentent un indice de réfraction $n_D^{20} > 1,55$.

9. Compositions de polyuréthane selon l'une quelconque des revendications 1 à 8, **caractérisées en ce qu'**on utilise dans le composant C) des uréthane-acrylates et des uréthane-méthacrylates à base d'isocyanates aromatiques et d'acrylate de 2-hydroxyéthyle, d'acrylate d'hydroxypropyle, d'acrylate de 4-hydroxybutyle, de poly(oxyde d'éthylène-mono(méth)acrylate), de poly(oxyde de propylène-mono(méth)acrylate), de poly(oxyde d'alkylène-mono(méth)acrylate) et de poly($\varepsilon$-caprolactone-mono(méth)acrylates).

10. Procédé pour la fabrication d'agents pour enregistrer des hologrammes visuels, dans lequel des compositions de polyuréthane selon l'une quelconque des revendications 1 à 9 sont appliquées sur un substrat ou dans un moule et durcies.

11. Agents pour enregistrer des hologrammes visuels pouvant être obtenus selon un procédé selon la revendication 10.

12. Utilisation d'agents selon la revendication 11 comme éléments optiques, images ou pour la représentation ou la projection d'images.

13. Procédé pour enregistrer un hologramme, dans lequel on utilise des agents selon la revendication 12.

**Figur 1:**

Figur 2:

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6743552 B
- US 6765061 B
- US 6780546 B
- JP 2008015154 A
- US 2003044690 A1
- JP 2008070464 A
- WO 2008029765 A1
- WO 2005116756 A2
- JP 2007101743 B
- JP 2007086234 B
- JP 2007101881 B
- US 20070077498 A
- US 20070072124 A
- JP 2007187968 B
- JP 2007272044 B
- JP 2008070464 B
- JP 2007279585 B
- US 5470813 A
- EP 700949 A
- EP 743093 A
- EP 761708 A
- WO 9740086 A
- WO 9816310 A
- WO 0047649 A
- US 200207043 A1
- US 200210374 A1
- EP 0223587 A

**In der Beschreibung aufgeführte Nicht-Patentliteratur**

- Roche Lexikon Medizin. Urban & Fischer Verlag, 1999
- Römpp Lexikon Chemie. Georg-Thieme-Verlag, 1998, 465-466
- Ullmanns Encyclopädie der industriellen Chemie. 1992, vol. A21, 670-671
- *J. Polym. Sci, Polym. Chem. Ed.,* 1985, vol. 28, 444-449
- **HOUBEN-WEYL.** Methoden der organischen Chemie. Georg Thieme Verlag, 1961, vol. XIV/1, 433ff
- **CUNNINGHAM et al.** *RadTech'98 North America UV/EB Conference Proceedings,* 19. April 1998
- **KUTAL et al.** *Macromolecules,* 1991, vol. 24, 6872
- **YAMAGUCHI et al.** *Macromolecules,* 2000, vol. 33, 1152
- **NECKERS et al.** *Macromolecules,* 2000, vol. 33, 7761
- **LI et al.** *Polymeric Materials Science and Engineering,* 2001, vol. 84, 139
- **DEKTAR et al.** *J. Org. Chem.,* 1990, vol. 55, 639
- *J. Org. Chem.,* 1991, vol. 56, 1838
- **CRIVELLO et al.** *Macromolecules,* 2000, vol. 33, 825
- **GU et al.** *Am. Chem. Soc. Polymer Preprints,* 2000, vol. 41 (2), 1266
- **HUA et al.** *Macromolecules,* 2001, vol. 34, 2488-2494
- **H. KOGELNIK.** *The Bell System Technical Journal,* November 1969, vol. 48 (9), 2909, , 2947